# FASCICULE DE BREVET EUROPEEN

(11) **EP 2 331 480 B1**
(45) Date de publication et mention de la délivrance du brevet: **08.10.2014**
(21) Numéro de dépôt: 09740449.5
(22) Date de dépôt: 07.08.2009
(51) Int. Cl.: C04B 35/117, C04B 35/185, C04B 35/581, C04B 35/587, C04B 35/596, H01T 13/00, H01T 13/20, H01T 13/38, C04B 35/00

(54) **CERAMIQUE SEMI-CONDUCTRICE**
HALBLEITERKERAMIK
SEMICONDUCTOR CERAMIC

(30) Priorité: 08.08.2008 FR 0855483
(43) Date de publication de la demande: 15.06.2011
(73) Titulaire: Drazenovic, Béatrice, 13015 Marseille (FR)
(72) Inventeur: Drazenovic, Béatrice, 13015 Marseille (FR)
(74) Mandataire: Lebkiri, Alexandre
(86) Numéro de dépôt international: PCT/FR2009/051573
(87) Numéro de publication internationale: WO 2010/015789

(56) Documents cités:
- EP-A- 0 180 928
- WO-A-97/34444
- US-A- 5 085 804
- KIMURA I ET AL: "Sintering and characterization of Al2O3-TiB2 composites" JOURNAL OF THE EUROPEAN CERAMIC SOCIETY, ELSEVIER SCIENCE PUBLISHERS, BARKING, ESSEX, GB, vol. 5, no. 1, 1 janvier 1989 (1989-01-01), pages 23-27, XP024175182 ISSN: 0955-2219 [extrait le 1989-01-01]
- STADLBAUER W ET AL: "AL2O3-TIB2 COMPOSITE CERAMICS" JOURNAL OF MATERIALS SCIENCE LETTERS, CHAPMAN AND HALL LTD. LONDON, GB, vol. 8, no. 10, 1 octobre 1989 (1989-10-01), pages 1217-1220, XP000083887 ISSN: 0261-8028
- MATSUSHITA J-I ET AL: "Pressureless sintering of TiB2Al2O3" NIPPON SERAMIKKUSU KYOKAI GAKUJUTSU ROMBUSHI - JOURNAL OF THE CERAMIC SOCIETY OF JAPAN, NIPPON SERAMIKKUSU KYOKAI, TOKYO, JP, vol. 97, no. 10, 1 janvier 1989 (1989-01-01), pages 1200-1205, XP009116788 ISSN: 0914-5400
- RAY S P: "Boride-alumina composites: synthesis and fabrication" METALLURGICAL TRANSACTIONS A- PHYSICAL METALLURGY AND MATERIALS SCIENCE, SPRINGER NEW YORK LLC, UNITED STATES, vol. 23A, no. 9, 1 septembre 1992 (1992-09-01), pages 2381-2385, XP009116789 ISSN: 0360-2133

## Description

### DOMAINE DE L'INVENTION

La présente invention concerne le domaine des céramiques semi-conductrices et des procédés de fabrication de telles céramiques semi-conductrice.

### ARRIERE PLAN DE L'INVENTION

Les systèmes d'allumage de moteur de turbomachines utilisent différentes technologies et notamment l'allumage par bougie, qui est par exemple utilisée pour l'allumage des turbines à gaz dans l'aéronautique et l'industrie.

Les turbomachines comprennent principalement trois éléments : le compresseur, la chambre de combustion et la turbine.

La bougie est placée dans la chambre de combustion. Cette bougie permet de véhiculer une énergie délivrée par un boîtier d'alimentation, et crée une étincelle en son extrémité. Cette étincelle est provoquée par le claquage d'un milieu gazeux entourant deux électrodes de la bougie.

Deux types de bougies sont actuellement utilisées : les bougies Haute Tension (20kV, tension d'amorçage qui augmente fortement aux hautes pressions) dans la chambre de combustion, et les bougies Basse Tension comprenant une céramique semi-conductrice enchâssée entre les deux électrodes de la bougie qui assurent une ionisation du milieu gazeux les séparant quelle que soit la pression dans la chambre de combustion.

L'avantage des bougies comprenant une céramique semi-conductrice est que la tension requise pour produire l'étincelle est constante et indépendante de la pression.

Les bougies d'allumage doivent pouvoir supporter des conditions d'utilisation extrême, notamment lors de leur utilisation dans l'aéronautique.

En cours d'utilisation, les bougies d'allumage comprenant une céramique semi-conductrice sont soumises à diverses contraintes.

L'une de ces contraintes concerne les chocs thermiques violents que doit supporter la bougie en raison du temps de montée en température très rapide de la chambre (de 0°C à 900°C en une minute).

Une autre contrainte concerne le passage d'une atmosphère très riche, donc très réductrice au décollage, à une atmosphère très pauvre, donc très oxydante en vol.

D'autres contraintes concernent les vibrations du moteur, le brouillard salin, l'humidité ou encore le gel.

C'est donc dans ces conditions extrêmes que doit pouvoir s'établir un arc électrique entre les deux électrodes de la bougie pour permettre l'allumage ou le réallumage du carburant dans la chambre de combustion.

La céramique semi-conductrice des bougies d'allumage actuelles est composée de deux phases dans les proportions suivantes : 40% SIALON et 60% SiC. La céramique de ce type de bougie possède une forte porosité de l'ordre de 15%. Cette porosité ouverte est répartie sur les surfaces intérieures et extérieures sur une profondeur d'environ un quart de l'épaisseur sur chaque face de la céramique. Les pores sont le siège de micro-décharges permettant le claquage du milieu gazeux dans ces microcavités.

Le SiC est un semi-conducteur à large bande interdite, grand champ de claquage (2 MV.cm-1) associé à une bonne conductivité thermique, ce qui en fait un matériau de choix pour dissiper de grandes puissances électriques.

Le Sialon offre quant à lui une résistance élevée à haute température. C'est un matériau dur, et résistant à l'usure. Chimiquement inerte et non affecté par les chocs thermiques, le Sialon possède un faible coefficient de dilatation et résiste à l'oxydation.

Toutefois l'inconvénient majeur des bougies comprenant une céramique semi-conductrice décrite ci-dessus réside dans leur faible durée de vie et leur mauvaise fiabilité.

En effet, le matériau semi-conducteur est rapidement dégradé par la combinaison des chocs thermiques violents, des températures maximales de plus en plus élevées et de l'atmosphère oxydante.

Le SiC s'oxyde à partir de 600°C ce qui fait dériver les propriétés électriques du matériau, induisant des défauts de conduction importants du matériau.

La porosité de la céramique fragilise le matériau et favorise son usure prématurée.

Par ailleurs, afin d'améliorer les rendements des moteurs thermiques et de diminuer les émissions nocives que ces moteurs rejettent dans l'atmosphère, il est nécessaire d'augmenter la température dans les chambres de combustion.

Avec cet accroissement de la sévérité des conditions de température et de pression dans les chambres de combustion, les bougies comprenant une céramique semi-conductrice actuelle deviennent inutilisables et atteignent donc leur limite technologique.

Un but de l'invention est de proposer une nouvelle céramique semi-conductrice permettant de pallier les inconvénients des céramiques semi-conductrices existantes à base de SiC et Sialon.

### BREVE DESCRIPTION DE L'INVENTION

A cet effet on prévoit une céramique semi-conductrice, caractérisée en ce qu'elle comporte :
- 5 à 40% en volume d'une phase (électriquement) conductrice particulaire,
- 60 à 95% en volume d'une phase (électriquement) isolante particulaire,
la taille des particules de la phase conductrice étant comprise entre 5 nm et 11 µm, et la distance entre deux particules voisines de phase conductrice étant comprise entre 30 Angströms et 5 µm.

De cette façon, on obtient une céramique possédant un comportement totalement isolant électriquement jusqu'à un certain seuil de tension électrique appliquée, puis un comportement conducteur électriquement, sans (ou avec un très faible) courant de fuite.

On notera qu'un avantage de l'invention est que le passage d'un état isolant électriquement à un état conducteur électriquement de la céramique est obtenu pour une composition fixe donnée, contrairement au cas d'une percolation classique où le passage d'un état isolant électriquement à un état conducteur électriquement est obtenu lorsqu'une proportion supplémentaire de phase conductrice électriquement est ajoutée. Ainsi, dans le cas de la présente invention, le passage de la céramique d'un état isolant à un état conducteur est obtenu pour une composition fixe donnée (car percolation lointaine par effet tunnel comme décrit plus en détail ci-dessous).

Avantageusement, 65 à 80% des particules de la phase conductrice présentent un diamètre moyen inférieur à 1 µm. Préférentiellement, 19.5 à 24% des particules de la phase conductrice ont un diamètre inférieur à 240 nm. Préférentiellement encore, 3.9 à 4.8% des particules de la phase conductrice ont un diamètre de 5 à 50 nm, 7.8 à 9.6% des particules de la phase conductrice ont un diamètre de 50 à 170 nm, et 7.8 à 9.6% des particules de la phase conductrice ont un diamètre de 170 à 240 nm.

Par ailleurs, 20 à 35% des particules de la phase conductrice présentent un diamètre moyen compris entre 1 et 11µm. Parmi ces 20 à 35%, entre 80% et 95% ont un diamètre inférieur à 3 µm.

On obtient une céramique possédant toujours le comportement isolant jusqu'à un certain seuil de tension appliquée puis devenant conductrice sans (ou avec un faible) courant de fuite.

On entend, dans le cadre de la présente invention, par « diamètre moyen d'une particule », la moyenne des diamètres que l'on obtient en considérant les cercles de même aire que la superficie apparente de la particule vue sous plusieurs angles.

Une telle microstructure permet une conduction par effet tunnel et « effet barrière ».

En effet, la percolation n'est pas ici un contact entre les particules conductrices, on utilise les propriétés de l'interface Inclusion/Matrice qui est une nouvelle phase dont les propriétés électriques sont modifiées.

Le seuil de percolation correspond alors à la fraction volumique de phase conductrice telle que les distances inter-particules permettent aux électrons de sauter d'une particule à l'autre en franchissant la barrière isolante.

Pour une interface d'épaisseur 30 Å à 5 nm, on a une conduction du type effet tunnel, dans ces conditions, le courant est insensible à la température.

La céramique commence à conduire, on a l'apparition de l'effet Joule, ainsi, pour une épaisseur d'interface supérieure à 5 nm, l'effet Schottky (ainsi que l'effet « hopping » (ou saut à distance variable) et l'effet Poole-Frenkel mais dans une moindre mesure), thermiquement activé par l'autochauffe de la céramique, permet un courant de conduction. L'effet de champ et la charge d'espace facilitent encore la conduction.

La céramique s'échauffe, la conduction thermique étant plus efficace que le rayonnement thermique, la conduction ne dépend pas de la température.

Les particules isolantes constituant les interfaces entre les particules conductrices doivent également posséder des propriétés spécifiques à savoir une taille limitée afin de permettre cette conduction.

La répartition des particules conductrices, plus précisément la distance les séparant permet donc de définir le seuil de conduction.

On obtient ainsi, selon l'arrangement des particules, une céramique semi-conductrice à seuil de conduction réglable.

Avant ce seuil la céramique est totalement isolante, il n'y a quasiment pas de courant de fuite.

On entend, dans le cadre de la présente invention, par « taille des particules », le diamètre moyen des particules.

Des aspects préférés mais non limitatifs de l'invention sont les suivants :
- le matériau constituant la phase conductrice est choisi parmi le groupe consistant en MoSi₂, TiB₂, TiN, Ni₃Si, HfB₂, ZrB₂ ;
- la taille des particules de la phase isolante est comprise entre 0.3 et 3 µm ;
- le matériau constituant la phase isolante est choisi parmi Al₂O₃, mullite, Si₃N₄ ;
- la céramique peut comporter 15 à 25% en volume de MoSi₂, et préférentiellement 21 à 24% en volume de MoSi₂ ;
- la céramique peut présenter une porosité inférieure ou égale à 10% et préférentiellement inférieure à 5% ;
- la phase conductrice à base de particules de MoSi₂ peut comprendre en outre entre 0% et 2% en poids de carbone ;
- la surface de la céramique semi-conductrice peut être vitrifiée ;
- la phase conductrice à base de particules de MoSi₂ peut comprendre en outre 1% en poids d'un élément choisi parmi Al, Ta, Ti, Zr, Y et B ;
- la céramique peut comprendre en outre 0,1 à 0,9% en poids de composé lanthanide ;

On prévoit également un procédé de fabrication d'une céramique semi-conductrice telle que décrite ci-dessus, le procédé comprenant les étapes suivantes :
- préparer une suspension homogène d'une phase conductrice particulaire pour obtenir une première barbotine,
- préparer une suspension homogène d'une phase isolante particulaire pour obtenir une deuxième barbotine,
- mélanger les première et deuxième barbotines pour obtenir un mélange des deux phases, la première barbotine représentant à 5 à 40% en volume du mélange et la deuxième barbotines représentant 60 à 95% en volume du mélange,
- effectuer un frittage de la composition pour obtenir une céramique dans laquelle la taille des particules de la phase conductrice est comprise entre 5 nm et 10 µm, et la distance entre deux particules voisines de phase conductrice est comprise entre 0,1 et 10 µm.

Avantageusement, le frittage peut être choisi parmi un frittage naturel, un frittage par presse à chaud, un frittage assisté par courant (SPS).

On prévoit également une bougie d'allumage du type à haute énergie basse tension, la bougie comportant entre ses électrodes une céramique semi-conductrice telle que décrite ci-dessus.

### BREVE DESCRIPTION DES DESSINS

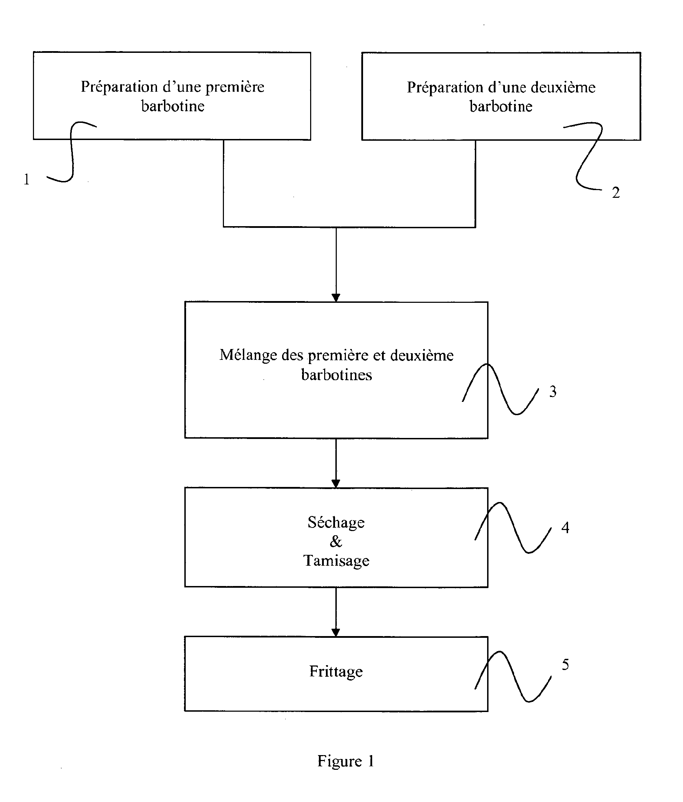

D'autres caractéristiques, buts et avantages de la présente invention ressortiront encore de la description qui suit, laquelle est purement illustrative et non limitative et doit être lue en regard de la figure 1 qui représente des étapes du procédé de fabrication de la céramique selon l'invention.

### DESCRIPTION DETAILLEE DE L'INVENTION

Une céramique semi-conductrice est composée d'une phase isolante et d'une phase conductrice.

Le mécanisme de fonctionnement des céramiques semi-conductrice actuelles à base de Sialon et SiC s'appuie sur les propriétés intrinsèques de l'un des constituants de la céramique (conduction de surface du SiC ajoutée à une porosité ouverte).

Or, les semi-conducteurs potentiellement utilisables de par leur caractéristiques électriques (GaN, ZnO, ...) sont à proscrire étant donnée leur faible résistance à l'oxydation.

Une solution est donc d'utiliser un composite formé d'une phase conductrice en inclusion dans une matrice isolante. Ceci permet d'obtenir un matériau globalement semi-conducteur avec une microstructure du même type que les céramiques semi-conductrices à base de Sialon et SiC (joints de grains, défauts...) et des propriétés thermomécaniques optimales.

Le processus d'amorçage ne dépend alors plus des propriétés intrinsèques d'un des constituants et de la microstructure de la surface, mais du matériau dans son approche globale.

Afin que les charges injectées ne soient pas conduites à travers le volume de la céramique, il faut que l'implantation des charges se fasse à une vitesse supérieure à la vitesse de conduction traduite par le temps de relaxation qui caractérise le retour à l'équilibre après interruption du champ.

En présence de grains conducteurs entourés de joints de grains isolants, les charges sont piégées à la surface des grains induisant ainsi une courbure des bandes de valence et de conduction avec formation d'une double barrière Schottky. Les joints de grains sont en effet assimilables à deux diodes Schottky dos à dos. Le piégeage induisant une charge d'espace, il existe donc un gradient de champ puis une relaxation de cette charge d'espace cette relaxation dépendant du temps de transit des porteurs et de l'épaisseur d'isolant. Plus l'épaisseur de l'isolant est grande, plus le temps de relaxation est grand et la tension de « claquage » (en fait de conduction) est élevée.

La conduction dans la céramique selon l'invention est contrôlée par plusieurs mécanismes :
- tout d'abord, aux interfaces de la céramique : l'émission Schottky (l'augmentation de l'émission électronique lorsque le champ électrique appliqué augmente est due à la diminution du travail d'extraction), qui détermine la qualité de l'injection et qui est fortement corrélée à la qualité des contacts et l'émission de champ ;
- puis, dans la masse de la céramique : l'effet Poole-Frenkel (piégeage/dépiégeage) et l'effet hopping (conduction par saut).

L'effet tunnel Fowler-Nordheim et la charge d'espace participent également à la conduction aussi bien aux interfaces que dans la masse.

La contrainte est portée désormais par la capacité du matériau à résister aux contraintes environnementales sévères.

Les matériaux envisageables pour la phase conductrice peuvent être le GaN, le MoSi₂, le HfB₂, le TiB₂, le ZrB₂ ou encore le TiN.

Des propriétés de ces matériaux sont données dans le tableau suivant :

| | GaN | MoSi2 | HfB2 | TiB2 | ZrB2 | TiN |
|---|---|---|---|---|---|---|
| Dureté Vickers (MPa) /MOHS | 1 | 8700-9200 | | 3000 | 2300 | 2300 |
| Conductivité thermique (Wm-1K-1) | 1.3 | 90 | | | | |
| Coefficient d'expansion thermique (10-6 K-1) | 3.17 | 6.8 | 5-7 | 7.8 | 5.9 | 8-8.5 |
| Résistivité (ohm cm) | 2. 10-6 | 2.2 10-5 | 10-5 | 7. 10-6 | 6. 10-6 | 50. 10-6 |
| Température de fusion °C | 2500 | 2020 | 3380 | 3225 | 3245 | 2950 |

Le disiliciure de molybdène (MoSi₂) semble être un matériau avantageux pour la réalisation de la phase conductrice en raison de ses qualités intrinsèques mais aussi de par sa capacité à résister à l'oxydation.

Les avantages induits par l'utilisation d'une base de MoSi₂ pour la phase conductrice sont que le MoSi₂ présente une haute température de fusion (2030°C), que le MoSi₂ présente une grande résistance à l'oxydation jusqu'à 1600°C, que le MoSi₂ présente une grande conductivité thermique 50 WMK, et que le MoSi₂ est thermodynamiquement stable.

Quand deux phases de conductivités électriques différentes sont mélangées, le composé résultant est susceptible de posséder une gamme très étendue de valeurs de conductivité. Les grains conducteurs de MoSi₂ se comportent comme des connexions entre des capacités dont le diélectrique est formé par l'Al₂O₃.

Près de la région critique, demeurent seulement quelques chemins de faisceaux percolant, le rôle des condensateurs devenant ainsi très important.

Avec une microstructure présentant de gros « paquets » d'alumine qui sont les condensateurs régissant le mécanisme de conduction, et qui sont trop volumineux pour permettre le passage des charges par effet tunnel, les charges restent piégées dans l'alumine et la conduction reste très limitée.

A l'inverse, lorsque les particules conductrices sont petites et surtout bien dispersées, on abaisse le seuil de percolation et on a une conduction instantanée dès l'application d'une tension, la distance inter-particules ayant été fortement abaissée.

Deux microstructures de mêmes compositions peuvent ainsi présenter des comportements totalement différents selon l'arrangement des deux phases et il est donc nécessaire d'avoir un compromis entre les deux cas extrêmes où les grains de MoSi₂ percolent et celui où aucun n'est en contact.

Dès lors, la microstructure selon l'invention est une répartition homogène des particules de MoSi₂ dans la matrice alumine (par particule on entend grain ou amas de grains de 15 nm à 5µm), ceci afin de permettre le passage des charges par effet tunnel, compenser l'arrachement de trop grosses particules de MoSi₂ qui entraînerait une rupture dans le processus de conduction par percolation lointaine et d'obtenir des propriétés mécaniques satisfaisantes.

La présence d'un « gradient de tailles de particules conductrices » au sein de la matrice isolante permet d'obtenir l'effet électrique global attendu (comportement totalement isolant puis conducteur du matériau). La distribution en taille des particules se fait par exemple selon le schéma suivant :
- « petites particules » : diamètre moyen inférieur à 240 nm (19.5 à 24% des particules de la phase conductrice);
- « particules moyennes » : diamètre moyen de 240 nm à 1 µm (45.5 à 56% des particules de la phase conductrice) ;
- « grosses particules » : diamètre moyen de 1 µm à 11 µm (20 à 35 % des particules de la phase conductrice).

Afin de ne pas obtenir un matériau conducteur dès l'application de la tension, il faut, pour un même ratio conducteur/isolant, limiter le passage des charges (pas de contact, pas de distances inter-particules uniformément faibles) ; c'est pourquoi ce gradient de tailles de particules est important.

Afin de retarder la conduction, on utilise des grosses particules, peu nombreuses et éloignées les unes des autres.

La probabilité du transfert par effet tunnel décroit avec la distance inter-particules ; lorsque l'on a des grosses particules, il faut compenser ces distances par des défauts dans la zone inter-particules ou par une présence de petites particules qui assurent une conduction toujours sans contact mais par effet tunnel rendu plus facile par les distances inter-particules plus petites.

Les particules moyennes sont d'une utilité « intermédiaire », elles assurent la conduction une fois qu'elle est établie (et peuvent jouer le rôle soit des grosses particules soit des petites selon l'endroit où elles se trouvent) et permettent d'homogénéiser le matériau.

La microstructure attendue est donc des grains ainsi que des agglomérats de grains de MoSi₂ (de tailles contrôlées) répartis uniformément dans la matrice.

On notera que, lorsqu'on diminue la taille de grains d'alumine, on augmente le nombre de joints de grains et on étend ainsi le nombre de régions de piégeage, la conduction augmentant ; la taille des grains d'alumine est donc également un facteur à contrôler.

On propose donc de réaliser une céramique semi-conductrice comportant :
- 5 à 40% en volume d'une phase conductrice particulaire, préférentiellement à base de particules de MoSi₂
- 60 à 95% en volume d'une phase isolante particulaire,
la taille des particules de la phase conductrice étant comprise entre 5 nm et 10 µm, et la distance entre deux particules voisines de phase conductrice étant comprise entre 0,1 et 10 µm.

Préférentiellement, on propose de réaliser une céramique semi-conductrice comportant :
- 10 à 30% en volume d'une phase conductrice à base de particules de MoSi₂,
- 70 à 90% en volume d'une phase isolante particulaire,
la taille des particules de MoSi₂ étant comprise entre 15 nm et 5 µm, et la distance entre deux particules voisines de MoSi₂ étant comprise entre 0,1 et 6 µm.

On entend, dans le cadre de la présente invention, par *« particule* », un grain ou un agrégat/amas de grains.

La méthode de mesure utilisée pour mesurer la taille des particules de MoSi₂ comprend l'observation au microscope électronique à balayage du faciès de rupture d'échantillons cassés. Les images sont ensuite retraitées à l'aide du logiciel ESIVISION AnalySIS 3.2. On obtient le diamètre moyen de la particule de MoSi₂.

Avantageusement, la céramique semi-conductrice peut comporter 15 à 25% en volume de MoSi₂, et préférentiellement 21 à 24% en volume de MoSi₂.

Un avantage de ce ratio est l'obtention d'une céramique particulièrement adaptée à l'utilisation en tant que matériau pour bougie d'allumage basse tension.

On entend selon la présente invention une « phase conductrice à base de particules de MoSi₂ » comme étant essentiellement constituée de ces particules. Elle peut toutefois comprendre d'autres constituants comme du carbone, le bore ou différents métaux.

De manière préférentielle, la phase conductrice selon l'invention comprend plus de 90 % de particules de MoSi₂, plus préférentiellement plus de 95 %, encore plus préférentiellement plus de 97 % de MoSi₂.

Dans une variante de réalisation de la céramique selon l'invention, la phase conductrice en MoSi₂ comprend entre 0,1% et 3% en masse (de la masse totale phase isolante+phase conductrice) d'un élément simple (C, B, etc.) ou d'une terre rare.

Un avantage de l'introduction de carbone (bore ou terre rare) est d'améliorer les propriétés mécaniques de la phase conductrice en MoSi₂.

La phase isolante peut être réalisée à base de Al2O3, de SiN4, de mullite (2 SiO2, 3 Al2O3), ou encore d'ALON.

Des propriétés de ces matériaux sont données dans le tableau suivant :

| | Al2O3 | Si3N4 | Mullite* (Al₆Si₂O₁₃) | ALON |
|---|---|---|---|---|
| Dureté Mohs /Vickers (MPa) | 9 | 1580 | | 7.5 |
| Conductivité thermiqueWm-1K-1) | 26-35 | 15-43 | 3-5 | 2.5 |
| Coefficient d'expansion thermique (10-6 K-1) | 6.7-9 | 3 | 5-6 | 2-3 |
| Résistivité (ohm cm) | 1014 | 1012 - 1015 | 1010 -1013 | 1011 - 1014 |
| Température de fusion °C | 2050 | 1900 | 1880 | 1470 |

Dans un mode de réalisation de la céramique selon l'invention, la phase isolante de la céramique est réalisée à base de Si3N4.

En effet, ce matériau présente une plus grande dureté, une plus grande conductivité thermique et une plus grande résistivité qu'Al2O3, la Mullite et l'ALON.

Dans un autre mode de réalisation de la céramique selon l'invention, la phase isolante est réalisée à base d'Al₂O₃.

En effet, l'alumine (Al₂O₃) présente une grande résistivité électrique une excellente tenue au fluage à des températures supérieures à 1400°C et une bonne résistance aux attaques chimiques. Par ailleurs, un avantage d'un composite de MoSi₂ et Al₂O₃ pour les phases conductrice et isolante de la céramique est que ces deux matériaux présentent des coefficients de dilatation proches, de sorte à diminuer les contraintes thermiques entre ces deux matériaux.

Avantageusement, la taille des particules de la phase isolante peut être comprise entre 0.3 et 3 µm.

La méthode de mesure utilisée pour mesurer la taille des particules de la phase isolante comprend l'observation au microscope électronique à balayage de du faciès de rupture d'échantillons cassés. Les images sont ensuite retraitées à l'aide du logiciel ESIVISION AnalySIS 3.2. On obtient le diamètre moyen des particules de la phase isolante.

La céramique semi-conductrice selon l'invention présente une porosité moyenne inférieure ou égale à 10%, et préférentiellement inférieure à 5%. Cette valeur de porosité est fonction de la technique employée pour réaliser la céramique. Par exemple, si on utilise un frittage naturel pour la fabrication de la céramique, la porosité moyenne est inférieure ou égale à 10%. Si on utilise un frittage par presse à chaud (HP pour *« Hot Press »* selon la terminologie anglo-saxonne), la porosité moyenne de la céramique est inférieure ou égale 2%. Enfin, si on utilise un frittage assisté par courant (SPS pour « *Spark Plasma Sintering »* selon la terminologie anglo-saxonne), la porosité moyenne de la céramique est inférieure ou égale à 3%. Toutes ces techniques de frittage seront décrites plus en détail dans la suite.

Contrairement aux céramiques de l'art antérieur à base de Sialon et SiC dont le bon fonctionnement nécessite la présence de porosités ouvertes (en association avec la propriété du SiC à conduire en surface), le mécanisme de fonctionnement (i.e. le processus d'amorçage) de la céramique selon l'invention dépend du matériau dans son approche globale. Le claquage de l'espace environnant les électrodes est assuré par la conduction des charges en surface induite par un développement pelliculaire assuré par un signal haute fréquence.

Ainsi, le mécanisme de fonctionnement de la céramique selon l'invention ne nécessite pas la présence de porosités ouvertes.

Toutefois, dans l'hypothèse où la céramique comprend des porosités ouvertes, la surface de la céramique semi-conductrice peut être vitrifiée. Ceci permet de minimiser le phénomène dit de *« Pest »* qui peut entraîner la désagrégation de la céramique semi-conductrice. La vitrification de la surface de la céramique semi-conductrice permet donc d'améliorer la solidité de la céramique.

Selon une variante permettant de minimiser le phénomène de Pest, la phase conductrice en MoSi₂ peut comprendre 1% en poids d'un élément choisi parmi Al, Ta, Ti, Zr, Y et B.

Avantageusement, la céramique semi-conductrice selon l'invention peut comprendre également 0,1 à 0,9% en poids de composé lanthanide (par exemple La2O3, ou encore La2B6). Un lanthanide (La2O3, LaB6) est un matériau favorisant l'émission électronique. Ainsi, son ajout, en faible quantité, dans la céramique semi-conductrice permet de renforcer la thermo-émission de la céramique semi-conductrice.

On va maintenant décrire un procédé de fabrication de la céramique semi-conductrice selon l'invention.

Afin de résoudre les problèmes de fiabilité dans le temps des céramiques électro conductrices, il faut savoir élaborer un matériau dans des conditions optimales, maîtriser sa microstructure afin d'obtenir les propriétés souhaitées.

Les caractéristiques électriques dépendent du pourcentage volumique de phase conductrice et du type de microstructure développée après frittage.

Le procédé d'élaboration dont les paramètres les plus importants conditionnent la microstructure et ainsi les caractéristiques physiques des échantillons frittés est de fait la phase primordiale.

Ces paramètres concernent notamment :
- la nature des poudres
- les proportions des phases isolante et conductrice
- la quantité et la composition des additifs
- les procédés de désagglomération
- la technique de mise en forme
- les conditions de frittage.

Le procédé de fabrication d'une céramique semi-conductrice comprend les étapes suivantes :
- préparation 1 d'une suspension homogène d'une phase conductrice, par exemple à base de particules de MoSi₂ pour obtenir une première barbotine,
- préparation 2 d'une suspension homogène d'une phase isolante particulaire pour obtenir une deuxième barbotine,
- mélange 3 des première et deuxième barbotines pour obtenir un mélange des deux phases dans les proportions recherchées (i.e. la première barbotine représentant à 5 à 40% en volume du mélange et la deuxième barbotines représentant 60 à 95% en volume du mélange),
- séchage et tamisage 4 de la composition;
- frittage 5 de la composition pour obtenir une céramique dans laquelle la taille des particules de la phase conductrice est comprise entre 5 nm et 10 µm, et la distance entre deux particules voisines de phase conductrice est comprise entre 30 Å et 5 µm.

Comme décrit précédemment, la phase conductrice peut être choisie parmi le groupe consistant en MoSi2, TiB2, TiN.

Par ailleurs, la phase isolante peut être à base d'alumine Al₂O₃ ou de mullite, Si3N4.

Pour préparer la première barbotine, la phase conductrice de MoSi₂ est mélangée avec de l'eau de pH compris entre 8 et 10.

Ceci permet d'améliorer l'homogénéité de la microstructure.

Pour préparer la deuxième barbotine, la phase isolante est mélangée avec de l'eau de pH égal à 10 contenant un dispersant, avantageusement un polymère tensioactif de type polyméthacrylate d'ammonium comme le DARVAN C commercialisé par VANDERBILT. Ce dispersant permet d'éviter l'agglomération des particules d'alumine Al₂O₃. Il est avantageusement introduit à hauteur de 0.1% en poids.

Les deux barbotines sont ensuite mélangées pour obtenir un mélange des deux phases. Le mélange intime des 2 barbotines est effectué à l'aide d'un tourne jarre ou broyeur à boulets. La durée de broyage est comprise entre 5 et 24 heures.

Le mélange est ensuite séché à l'étuve pendant 48 heures. Afin d'éviter la sédimentation différentielle des deux types de particules, un séchage rapide par ROTOVAP peut être envisagé.

La poudre ainsi obtenue est broyée dans un mortier ; puis déposée avec des billes de verres (diamètre 10 mm) dans un tamis de maille 250 µm d'une tamiseuse électrique, la poudre passée à 250 µm se déverse dans un tamis de maille 100 µm contenant des billes d'alumine (diamètre 3mm).

La poudre composite ainsi recueillie et sommairement granulée est prête à être mise en forme, puis frittée.

L'étape de mise en forme est optionnelle. Sa mise en oeuvre dépend de la technologie de frittage utilisée. L'étape de mise en forme transforme le matériau en un produit cru ayant la taille, la forme et la surface contrôlée et la densité et la microstructure particulière.

Le contrôle attentif de la densité et de la microstructure d'une céramique en cru est nécessaire pour obtenir la performance du produit final car les défauts introduits par le procédé de mise en forme sont généralement non éliminables en frittage.

Une surface lisse et régulière est normalement désirable et peut être essentielle pour certains produits. La résistance doit être suffisante pour effectuer les opérations qui suivent la mise en forme. La reproductibilité du produit est très importante pour une production industrielle. La taille et la densité de la pièce crue doit être contrôlée afin de maintenir un facteur de retrait constant entre la pièce crue et frittée.

Pour l'étape de mise en forme on peut utiliser la technologie dite de compactation ou de compactation sèche.

La compaction est un procédé de mise en forme de poudre ou de matériau granulé enfermé dans un moule rigide ou souple.

La compaction sèche est un procédé largement utilisé en raison de sa reproductibilité et de son aptitude à produire des pièces de grand format et de différentes formes ne représentant pas de retrait au séchage. Elle comprend les étapes suivantes:
(1) remplissage de la matrice;
(2) compaction et mise en forme;
(3) éjection de la pièce.
(4) densification.

On effectue ensuite le frittage de la composition. Contrairement à la cuisson céramique, le frittage ne fait pas intervenir, en principe, une liaison des particules par une phase vitreuse. La cohérence et la densification des poudres pressées se produisent par suite de transformations affectant la surface des particules et conduisant à des interfaces solide-solide appelées joints de grains.

Les conditions de frittage déterminent la microstructure donc les propriétés du matériau final.

Avantageusement, on peut utiliser différentes technologies pour le frittage de la composition. Par exemple, dans un mode de réalisation du procédé, le frittage est un frittage naturel Dans un autre mode de réalisation, le frittage est un frittage par presse à chaud. Dans un autre mode de réalisation encore, le frittage est un frittage assisté par courant (SPS).

Pour la mise en oeuvre d'un frittage par presse à chaud, le four presse utilisé est de type Goliath (Stein Heurtey Physitherm) combinant une presse (charge maximale 20 tonnes) et un four à résistance de graphite (température maximale 2200°C) dont l'utilisation nécessite une atmosphère inerte ou un vide poussé.

Le contrôle de la température est assuré par un thermocouple tungstène/rhénium 5/26% placé à proximité du résistor ainsi que par un pyromètre bichromatique (IRCON) qui mesure la température réelle à la surface de l'outillage.

Le frittage par presse à chaud (HP) permet d'obtenir des pastilles de 37 mm. Il ne nécessite aucune mise en forme des pastilles.

Une densification optimale de la céramique est obtenue pour une température comprise entre 1600°C et 1700°C (et préférentiellement égale à 1650°C) et une charge de 45MPa.

La température permettant d'obtenir le meilleur compromis densification/ microstructure favorable au comportement électrique attendu est 1500°C.

Pour la mise en oeuvre d'un frittage naturel, on utilise le même four que celui utilisé pour le pressage à chaud. Simplement, dans ce cas de figure les échantillons sont placés après l'étape de mise en forme dans un creuset en graphite, et ne sont pas soumis à une charge durant le frittage.

Afin de limiter les échanges gazeux avec l'extérieur, on place les pastilles préformées dans un creuset en alumine pour la « cuisson en bogue », c'est-à-dire l'utilisation de poudre non tassée de même nature que les pastilles et les enrobant afin d'éviter tout contact avec l'atmosphère du four.

On peut également réaliser un frittage assisté par courant (SPS), comme décrit précédemment. Le frittage assisté par courant (SPS) permet de densifier les matériaux en conservant les caractéristiques des poudres initiales et de densifier des matériaux difficiles.

Le frittage assisté par courant (SPS) est un procédé similaire au pressage à chaud conventionnel. Les précurseurs (métaux, céramiques, polymères et leurs composites...) sont introduits dans une enceinte (en graphite) permettant d'appliquer une pression uniaxiale lors du frittage.

La différence majeure dans ce procédé réside dans le fait que la source de chaleur n'est pas externe. Un courant électrique (continu - continu pulsé - ou alternatif) passe à travers l'enceinte de pressage conductrice et également dans les cas appropriés à travers l'échantillon.

Ainsi, l'enceinte elle-même agit donc en tant que source de chauffage ce qui permet d'obtenir des vitesses de chauffage élevées (jusqu'à 600 °C/min et plus) et un bon transfert de la chaleur à l'échantillon. Des objets frittés de très grande compacité peuvent être obtenus pour des températures plus faibles (quelques centaines de degrés moins élevées) et surtout des temps de frittage significativement plus courts (quelques minutes) que pour les méthodes conventionnelles. Le frittage assisté par courant (SPS) est une technique extrêmement prometteuse en vue d'améliorer la mise en forme des matériaux déjà existants.

La densification est augmentée par l'utilisation d'un courant ou d'un champ puisé.

Le lecteur aura compris que de nombreuses modifications peuvent être apportées à la céramique semi-conductrice et à son procédé de fabrication décrits précédemment sans sortir matériellement des nouveaux enseignements et des avantages décrits ici.

Par conséquent, toutes les modifications de ce type sont destinées à être incorporées à l'intérieur de la portée de la céramique et de son procédé de fabrication tels que définis dans les revendications jointes.

En outre, même si la céramique selon l'invention trouve une application particulièrement intéressante dans le domaine des bougies pour l'allumage des turbomachines dans le domaine de l'industrie aéronautique, d'autres applications sont toutefois également envisageables (réalisation de varistances par exemple).

## Revendications

1. Céramique semi-conductrice, **caractérisée en ce qu'**elle comporte une microstructure comprenant :
- 5 à 40% en volume d'une phase conductrice particulaire,
- 60 à 95% en volume d'une phase isolante particulaire,
la taille des particules de la phase conductrice étant comprise entre 5 nm et 11 µm, 65 à 80% des particules conductrices présentant un diamètre moyen inférieur à 1 µm et 20 à 35% des particules conductrices présentant un diamètre moyen compris entre 1 et 11µm ;
la distance entre deux particules voisines de phase conductrice étant comprise entre 30 Angströms et 5 µm.

2. Céramique semi-conductrice selon la revendication précédente, **caractérisée en ce que** le matériau constituant la phase conductrice est choisi parmi le groupe consistant en MoSi₂, TiB₂, TiN, Ni₃Si, HfB₂, ZrB₂.

3. Céramique semi-conductrice selon l'une des revendications 1 à 2, **caractérisé en ce que** la taille des particules de la phase isolante est comprise entre 0.3 et 3 µm.

4. Céramique semi-conductrice selon l'une des revendications 1 à 3, **caractérisée en ce que** le matériau constituant la phase isolante est choisi parmi Al₂O₃, mullite, Si₃N₄.

5. Céramique semi-conductrice selon l'une des revendications 1 à 4, **caractérisée en ce qu'**elle comporte 15 à 25% en volume de MoSi₂, et préférentiellement 21 à 24% en volume de MoSi₂.

6. Céramique semi-conductrice selon l'une des revendications 1 à 5, **caractérisée en ce que** la céramique présente une porosité inférieure ou égale à 10% et préférentiellement inférieure à 5%.

7. Céramique semi-conductrice selon l'une des revendications 1 à 6, **caractérisée en ce que** la phase conductrice à base de particules de MoSi₂ comprend en outre entre 0% et 2% en poids de carbone.

8. Céramique semi-conductrice selon l'une des revendications 1 à 7, **caractérisée en ce que** la surface de la céramique semi-conductrice est vitrifiée.

9. Céramique semi-conductrice selon l'une des revendications 1 à 8, **caractérisée en ce que** la phase conductrice à base de particules de MoSi₂ comprend en outre 1% en poids d'un élément choisi parmi Al, Ta, Ti, Zr, Y et B.

10. Céramique semi-conductrice selon l'une des revendications 1 à 9, **caractérisé en ce qu'**elle comprend en outre 0,1 à 0,9% en poids de composé lanthanide.

11. Procédé de fabrication d'une céramique semi-conductrice selon l'une des revendications 1 à 10, **caractérisé en ce qu'**il comprend les étapes suivantes :
préparer (1) une suspension homogène d'une phase conductrice particulaire pour obtenir une première barbotine,
préparer (2) une suspension homogène d'une phase isolante particulaire pour obtenir une deuxième barbotine,
- mélanger (3) les première et deuxième barbotines pour obtenir un mélange des deux phases, la première barbotine représentant à 5 à 40% en volume du mélange et la deuxième barbotines représentant 60 à 95% en volume du mélange,
- effectuer un frittage (5) de la composition pour obtenir une céramique dans laquelle la taille des particules de la phase conductrice est comprise entre 5 nm et 10 µm, et la distance entre deux particules voisines de phase conductrice est comprise entre 0,1 et 10 µm.

12. Procédé selon la revendication 11, **caractérisé en ce que** le frittage est choisi parmi un frittage naturel, un frittage par presse à chaud, un frittage assisté par courant (SPS).

13. Bougie d'allumage du type à haute énergie basse tension, **caractérisé en ce qu'**elle comporte entre ses électrodes une céramique semi-conductrice selon l'une des revendications 1 à 10.

## Patentansprüche

1. Halbleitende Keramik, **dadurch gekennzeichnet dass** sie ein Mikrogefüge umfasst, bestehend aus:
- 5 bis 40 Vol.-% einer leitfähigen partikulären Phase;
- 60 bis 95 Vol.-% einer isolierenden partikulären Phase,
wobei die Größe der Teilchen der leitfähigen Phase zwischen 5µm und 11µm liegt, 65 bis 80% der leitfähigen Teilchen einen durchschnittlichen Durchmesser von weniger als 1 µm und 20 bis 35% der leitfähigen Teilchen einen durchschnittlichen Durchmesser von 1 bis 11 µm haben;
der Abstand zwischen zwei benachbarten Teilchen der leitfähigen Phase liegt zwischen 30 Å und 5 µm.

2. Halbleitende Keramik gemäß dem voranstehenden Anspruch, **dadurch gekennzeichnet, dass** das Material der leitfähigen Phase ausgewählt wird aus der Gruppe bestehend aus MoSi₂, TiB₂, TiN, Ni₃Si, HfB₂, ZrB₂.

3. Halbleitende Keramik gemäß einem der Ansprüche 1 bis 2, **dadurch gekennzeichnet, dass** die Größe der Teilchen der isolierenden Phase zwischen 0,3 und 3 µm liegt.

4. Halbleitende Keramik gemäß einem der Ansprüche 1 bis 3, **dadurch gekennzeichnet, dass** das Material der isolierenden Phase ausgewählt wird aus der Gruppe Al₂O₃, Mullit, Si₃N₄.

5. Halbleitende Keramik gemäß einem der Ansprüche 1 bis 4, **dadurch gekennzeichnet, dass** 15 bis 25 Vol.-% aus MoSi₂, und bevorzugt 21 bis 24 Vol.-% aus MoSi₂ besteht.

6. Halbleitende Keramik gemäß einem der Ansprüche 1 bis 5, **dadurch gekennzeichnet, dass** die Keramik eine Porosität von weniger oder gleich 10 %, und bevorzugt weniger als 5 % aufweist.

7. Halbleitende Keramik gemäß einem der Ansprüche 1 bis 6, **dadurch gekennzeichnet, dass** die leitfähige Phase auf der Basis von MoSi₂-Teilchen, darüber hinaus in Gewichtsanteilen 0 bis 2 % Kohlenstoff umfasst.

8. Halbleitende Keramik gemäß einem der Ansprüche 1 bis 7, **dadurch gekennzeichnet, dass** die Oberfläche der halbleitenden Keramik glasiert ist.

9. Halbleitende Keramik gemäß einem der Ansprüche 1 bis 8, **dadurch gekennzeichnet, dass** die leitfähige Phase auf der Basis von MoSi₂-Teilchen, darüber hinaus in Gewichtsanteilen 1% eines der Elemente Zl, Ta, Ti, Zr Y und B umfasst.

10. Halbleitende Keramik gemäß einem der Ansprüche 1 bis 9, **dadurch gekennzeichnet, dass** sie darüber hinaus in Gewichtsanteilen 0,1 bis 0,9 % einer Lanthanidverbindung umfasst.

11. Fertigungsverfahren einer halbleitenden Keramik gemäß einem der Ansprüche 1 bis 10, **dadurch gekennzeichnet, dass** es aus folgenden Verfahrensschritten besteht:
- Vorbereitung (1) einer homogenen Suspension aus einer leitfähigen partikulären Phase, zur Herstellung eines ersten Schlickers,
- Vorbereitung (2) einer homogenen Suspension aus einer isolierenden partikulären Phase, zur Herstellung eines zweiten Schlickers,
- Herstellung eines Gemischs (3) aus dem ersten und zweiten Schlicker, um ein Gemisch aus beiden Phasen zu erzielen, wobei der erste Schlicker 5 bis 40 Vol.-% des Gemischs und der zweite Schlicker 60 bis 95 Vol.-%-des Gemischs umfasst,
- Durchführung eines Sintervorgangs (5) der Zusammensetzung zur Herstellung einer Keramik, bei der die Teilchengröße der leitfähigen Phase zwischen 5 und 10 µm und der Abstand zwischen zwei benachbarten Teilchen der leitfähigen Phase zwischen 0,1 und 10 µm liegen.

12. Verfahren gemäß Anspruch 11, **dadurch gekennzeichnet, dass** der Sintervorgang mittels natürlichem Sintern, durch Heißpressen oder SPS-Verfahren(Spark Plasma Sintern)erfolgt.

13. Hochenergie-Niederspannungszündkerze, **dadurch gekennzeichnet, dass** sie zwischen ihren Elektroden eine halbleitende Keramik gemäß einem der Ansprüche 1 bis 10 umfasst.

## Claims

1. Semiconductor ceramic **characterised in that** it comprises a microstructure comprising:
- 5 to 40% by volume of a particulate conductive phase,
- 60 to 95% by volume of a particulate insulating phase,
where the size of the particles of the conductive phase is between 5 nm and 11µm, where 65 to 85% of conductive particles have a mean diameter of less than 1 µm and where 20 to 35% of conductive particles have a mean diameter of between 1 and 11µm;
where the distance between two neighbouring conductive phase particles is between 30 Angstroms and 5 µm.

2. Semi-conductive ceramic according to the preceding claim, **characterised in that** the material constituting the conductive phase is selected from the group consisting of MoSi₂, TiB₂, TiN, Ni₃Si, HfB₂, ZrB₂.

3. Semi-conductive ceramic according to one of claims 1 to 2, **characterised in that** the size of the particles of the insulating phase is between 0.3 and 3 µm.

4. Semi-conductive ceramic according to one of claims 1 to 3, **characterised in that** the material constituting the insulating phase is selected from Al₂O₃, mullite, Si₃N₄.

5. Semi-conductive ceramic according to one of claims 1 to 4, **characterised in that** it comprises 15 to 25% by volume of MoSi₂, and preferably 21 to 24% by volume of MoSi₂.

6. Semi-conductive ceramic according to one of claims 1 to 5, **characterised in that** the ceramic has a porosity which is less than or equal to 10% and preferably less than 5%.

7. Semi-conductive ceramic according to one of claims 1 to 6, **characterised in that** the conductive phase based on particles of MoSi₂ moreover comprises between 0% and 2% by weight of carbon.

8. Semi-conductive ceramic according to one of claims 1 to 7, **characterised in that** the surface of the semi-conductive ceramic is vitrified.

9. Semi-conductive ceramic according to one of claims 1 to 8, **characterised in that** the conductive phase based on particles of MoSi₂ moreover comprises 1% by weight of an element selected from Al, Ta, Ti, Zr, Y and B.

10. Semi-conductive ceramic according to one of claims 1 to 9, **characterised in that** it moreover comprises 0.1 to 0.9% by weight of lanthanide compound.

11. Method of manufacturing a semi-conductive ceramic according to one of claims 1 to 10, **characterised in that** it comprises the following steps:
- prepare (1) a homogeneous suspension of a particulate conductive phase in order to obtain a first slurry,
- prepare (2) a homogeneous suspension of a particulate insulating phase in order to obtain a second slurry,
- mix (3) the first and second slurries in order to obtain a mixture of the two phases, with the first slurry representing from 5 to 40% by volume of the mixture and the second slurries representing 60 to 95% by volume of the mixture,
- carry out sintering (5) of the composition in order to obtain a ceramic wherein the size of the particles of the conductive phase is between 5 nm and 10 µm, and the distance between two neighbouring particles of conductive phase is between 0.1 and 10 µm.

12. Method according to claim 11, **characterised in that** the sintering is selected from natural sintering, hot press sintering and spark plasma sintering (SPS).

13. High-energy, low-voltage type spark plug, **characterised in that** it comprises a semi-conductive ceramic according to one of claims 1 to 10 between its electrodes.
